(19) Europäisches Patentamt
European Patent Office
Office européen des brevets

(11) EP 3 730 545 A1

(12) EUROPEAN PATENT APPLICATION

(43) Date of publication:
**28.10.2020 Bulletin 2020/44**

(21) Application number: **19171258.7**

(22) Date of filing: **26.04.2019**

(51) Int Cl.:
***C08K 3/11*** *(2018.01)*
*C08K 3/08* *(2006.01)*
*C08L 69/00* *(2006.01)*
*C08L 71/00* *(2006.01)*
*C08L 77/00* *(2006.01)*
*C08L 81/02* *(2006.01)*
*H05K 1/00* *(2006.01)*

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **SABIC Global Technologies B.V.**
**4612 PX Bergen op Zoom (NL)**

(72) Inventors:
- **FANG, Yapeng (Eric)**
  **Pudong New Area, Shanghai 201319 (CN)**
- **SONG, Shijie**
  **Pudong New Area, Shanghai 201319 (CN)**
- **WANG, Jian**
  **Pudong New Area, Shanghai 201319 (CN)**

(74) Representative: **Elzaburu S.L.P.**
**Miguel Angel 21, 2nd floor**
**28010 Madrid (ES)**

(54) **LASER PLATABLE THERMOPLASTIC COMPOSITIONS**

(57) A laser platable thermoplastic composition includes from about 40 wt% to about 90 wt% of a thermoplastic polymer, from about 1 wt% to about 15 wt% of a laser activatable metal compound, and from about 1 wt% to about 60 wt% of a magnetic filler. The magnetic filler includes a magnetic alloy. Methods for making laser platable thermoplastic compositions and articles formed therefrom - such as an induction heater for a domestic or commercial appliance - are also described.

EP 3 730 545 A1

## Description

### FIELD OF THE DISCLOSURE

The present disclosure relates to laser platable thermoplastic compositions, and in particular to laser platable thermoplastic compositions including a magnetic alloy.

### BACKGROUND OF THE DISCLOSURE

Laser direct structuring (LDS) is a Molded Interconnect Device (MID) technology that allows for the manufacture of conductive path structures on nonconductive material surfaces. LDS has been widely used in electronic applications such as antennas and circuits. Compared to the conventional fabrication methods for these components such as hot stamping and 2-shot molding, LDS provides advantages in design capability, cycle time, cost efficiency, miniaturization, diversification and functionality of the devices. As a result, LDS fabrication processes have been widely adopted in the electronic industry.

A successful commercial application of LDS technology is for fabricating internal antennas for mobile devices such as mobile phones, tablets, laptops and wearable devices. Recently, a new application for LDS technology has been found as a replacement for the traditional copper coil found in home appliances such as the induction rice cooker. By using LDS technology, the weight and volume of the induction heater can be reduced, which provides a better distribution of heat generated by the circuit plate. However, compared to traditional copper coil performance, the LDS design has a lower inductance, which reduces the heating capability of circuit plate. One way to solve this problem is by including soft magnetic strips, which have a high magnetic permeability and low magnetic loss, around the circuit plate. Unfortunately, such solutions are somewhat undesirable because they increase the volume and weight of the circuit plate.

These and other shortcomings are addressed by aspects of the present disclosure.

### SUMMARY

Aspects of the disclosure relate to laser platable thermoplastic compositions including: from about 40 wt% to about 90 wt% of a thermoplastic polymer; from about 1 wt% to about 15 wt% of a laser activatable metal compound; and from about 1 wt% to about 60 wt% of a magnetic filler including a magnetic alloy. The combined weight percent value of all components does not exceed 100 wt%, and all weight percent values are based on the total weight of the composition.

Aspects of the disclosure further relate to methods for forming a laser platable thermoplastic composition including: forming a mixture by combining from about 40 wt% to about 90 wt% of a thermoplastic polymer, from about 1 wt% to about 15 wt% of a laser activatable metal compound, and from about 1 wt% to about 60 wt% of a magnetic filler including a magnetic alloy; and extruding or melt-blending the mixture to form the composition.

### DETAILED DESCRIPTION

To address this problem, the current relates to laser platable thermoplastic compositions - and methods for making them - which have enhanced magnetic permeability, low magnetic loss, easy processing and balanced mechanical properties. The present disclosure can be understood more readily by reference to the following detailed description of the disclosure and the Examples included therein. In various aspects, the present disclosure pertains to a laser platable thermoplastic composition including: from about 40 wt% to about 90 wt% of a thermoplastic polymer; from about 1 wt% to about 15 wt% of a laser activatable metal compound; and from about 1 wt% to about 60 wt% of a magnetic filler. The magnetic filler includes a magnetic alloy.

Before the present compounds, compositions, articles, systems, devices, and/or methods are disclosed and described, it is to be understood that they are not limited to specific synthetic methods unless otherwise specified, or to particular reagents unless otherwise specified, as such can, of course, vary. It is also to be understood that the terminology used herein is for the purpose of describing particular aspects only and is not intended to be limiting.

Various combinations of elements of this disclosure are encompassed by this disclosure, e.g., combinations of elements from dependent claims that depend upon the same independent claim.

Moreover, it is to be understood that unless otherwise expressly stated, it is in no way intended that any method set forth herein be construed as requiring that its steps be performed in a specific order. Accordingly, where a method claim does not actually recite an order to be followed by its steps or it is not otherwise specifically stated in the claims or descriptions that the steps are to be limited to a specific order, it is in no way intended that an order be inferred, in any respect. This holds for any possible non-express basis for interpretation, including: matters of logic with respect to

arrangement of steps or operational flow; plain meaning derived from grammatical organization or punctuation; and the number or type of aspects described in the specification.

All publications mentioned herein are incorporated herein by reference to disclose and describe the methods and/or materials in connection with which the publications are cited.

## Definitions

It is also to be understood that the terminology used herein is for the purpose of describing particular aspects only and is not intended to be limiting. As used in the specification and in the claims, the term "comprising" can include the aspects "consisting of' and "consisting essentially of." Unless defined otherwise, all technical and scientific terms used herein have the same meaning as commonly understood by one of ordinary skill in the art to which this disclosure belongs. In this specification and in the claims which follow, reference will be made to a number of terms which shall be defined herein.

As used in the specification and the appended claims, the singular forms "a," "an" and "the" include plural referents unless the context clearly dictates otherwise. Thus, for example, reference to "a thermoplastic polymer" includes mixtures of two or more thermoplastic polymers.

As used herein, the term "combination" is inclusive of blends, mixtures, alloys, reaction products, and the like.

Ranges can be expressed herein as from one value (first value) to another value (second value). When such a range is expressed, the range includes in some aspects one or both of the first value and the second value. Similarly, when values are expressed as approximations, by use of the antecedent 'about,' it will be understood that the particular value forms another aspect. It will be further understood that the endpoints of each of the ranges are significant both in relation to the other endpoint, and independently of the other endpoint. It is also understood that there are a number of values disclosed herein, and that each value is also herein disclosed as "about" that particular value in addition to the value itself. For example, if the value "10" is disclosed, then "about 10" is also disclosed. It is also understood that each unit between two particular units are also disclosed. For example, if 10 and 15 are disclosed, then 11, 12, 13, and 14 are also disclosed.

As used herein, the terms "about" and "at or about" mean that the amount or value in question can be the designated value, approximately the designated value, or about the same as the designated value. It is generally understood, as used herein, that it is the nominal value indicated $\pm$10% variation unless otherwise indicated or inferred. The term is intended to convey that similar values promote equivalent results or effects recited in the claims. That is, it is understood that amounts, sizes, formulations, parameters, and other quantities and characteristics are not and need not be exact, but can be approximate and/or larger or smaller, as desired, reflecting tolerances, conversion factors, rounding off, measurement error and the like, and other factors known to those of skill in the art. In general, an amount, size, formulation, parameter or other quantity or characteristic is "about" or "approximate" whether or not expressly stated to be such. It is understood that where "about" is used before a quantitative value, the parameter also includes the specific quantitative value itself, unless specifically stated otherwise.

Disclosed are the components to be used to prepare the compositions of the disclosure as well as the compositions themselves to be used within the methods disclosed herein. These and other materials are disclosed herein, and it is understood that when combinations, subsets, interactions, groups, etc. of these materials are disclosed that while specific reference of each various individual and collective combinations and permutation of these compounds cannot be explicitly disclosed, each is specifically contemplated and described herein. For example, if a particular compound is disclosed and discussed and a number of modifications that can be made to a number of molecules including the compounds are discussed, specifically contemplated is each and every combination and permutation of the compound and the modifications that are possible unless specifically indicated to the contrary. Thus, if a class of molecules A, B, and C are disclosed as well as a class of molecules D, E, and F and an example of a combination molecule, A-D is disclosed, then even if each is not individually recited each is individually and collectively contemplated meaning combinations, A-E, A-F, B-D, B-E, B-F, C-D, C-E, and C-F are considered disclosed. Likewise, any subset or combination of these is also disclosed. Thus, for example, the sub-group of A-E, B-F, and C-E would be considered disclosed. This concept applies to all aspects of this application including, but not limited to, steps in methods of making and using the compositions of the disclosure. Thus, if there are a variety of additional steps that can be performed it is understood that each of these additional steps can be performed with any specific aspect or combination of aspects of the methods of the disclosure.

References in the specification and concluding claims to parts by weight of a particular element or component in a composition or article, denotes the weight relationship between the element or component and any other elements or components in the composition or article for which a part by weight is expressed. Thus, in a compound containing 2 parts by weight of component X and 5 parts by weight component Y, X and Y are present at a weight ratio of 2:5, and are present in such ratio regardless of whether additional components are contained in the compound.

A weight percent of a component, unless specifically stated to the contrary, is based on the total weight of the

formulation or composition in which the component is included.

As used herein, the terms "number average molecular weight" or "Mn" can be used interchangeably, and refer to the statistical average molecular weight of all the polymer chains in the sample and is defined by the formula:

$$M_n = \frac{\sum N_i M_i}{\sum N_i},$$

where Mi is the molecular weight of a chain and Ni is the number of chains of that molecular weight. Mn can be determined for polymers, e.g., polycarbonate polymers, by methods well known to a person having ordinary skill in the art using molecular weight standards, e.g. polycarbonate standards or polystyrene standards, preferably certified or traceable molecular weight standards.

The terms "BisA," "BPA," or "bisphenol A," which can be used interchangeably, as used herein refers to a compound having a structure represented by the formula:

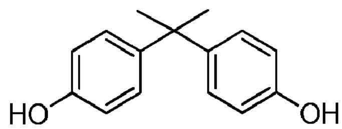

BisA can also be referred to by the name 4,4'-(propane-2,2-diyl)diphenol; p,p'-isopropylidenebisphenol; or 2,2-bis(4-hydroxyphenyl)propane. BisA has the CAS # 80-05-7.

As used herein, "polycarbonate" refers to an oligomer or polymer including residues of one or more dihydroxy compounds, e.g., dihydroxy aromatic compounds, joined by carbonate linkages; it also encompasses homopolycarbonates, copolycarbonates, and (co)polyester carbonates.

As used herein, "poly(p-phenylene oxide)" refers to polymers containing optionally substituted phenyl rings linked with oxygen (O) and can be used interchangeably with poly(p-phenylene ether) or poly (2,6 dimethyl-p-phenylene oxide). Poly(p-phenylene oxide) may be included by itself or may be blended with other polymers, including but not limited to polystyrene, high impact styrene-butadiene copolymer and/or polyamide.

As used herein, "polyamide" refers to a polymer having repeating units linked by amide bonds, and can include aliphatic polyamides (e.g., the various forms of nylon such as nylon 6 (PA6), nylon 66 (PA66) and nylon 9 (PA9)), polyphthalamides (e.g., PPA/high performance polyamide) and aramids (e.g., para-aramid and meta-aramid).

As used herein, "polyphenylene sulfide" refers to a polymer having a symmetrical, rigid backbone chain including recurring aromatic rings linked by sulfides.

As used herein, "polyester" refers to a polymer containing an ester functional group in the backbone of the polymer.

As used herein, "polyetherketone" refers to polymers containing ether and carbonyl groups in each monomer. In some aspects, the polyetherketone contains two ethers and one carbonyl group in each monomer. "Polyethersulfone" refers to polymers containing ether and sulfone groups in each monomer. In some aspects, the polyetherketone contains two ethers and one sulfone group in each monomer.

The terms "residues" and "structural units", used in reference to the constituents of the polymers, are synonymous throughout the specification.

As used herein the terms "weight percent," "wt%," and "wt. %," which can be used interchangeably, indicate the percent by weight of a given component based on the total weight of the composition, unless otherwise specified. That is, unless otherwise specified, all wt% values are based on the total weight of the composition. It should be understood that the sum of wt% values for all components in a disclosed composition or formulation are equal to 100.

Unless otherwise stated to the contrary herein, all test standards are the most recent standard in effect at the time of filing this application.

Each of the materials disclosed herein are either commercially available and/or the methods for the production thereof are known to those of skill in the art.

It is understood that the compositions disclosed herein have certain functions. Disclosed herein are certain structural requirements for performing the disclosed functions and it is understood that there are a variety of structures that can perform the same function that are related to the disclosed structures, and that these structures will typically achieve the same result.

## Laser Platable Thermoplastic Compositions

Aspects of the disclosure relate to laser platable thermoplastic compositions including: from about 40 wt% to about 90 wt% of a thermoplastic polymer; from about 1 wt% to about 15 wt% of a laser activatable metal compound; and from about 1 wt% to about 60 wt% of a magnetic filler. The magnetic filler includes a magnetic alloy. The combined weight percent value of all components does not exceed 100 wt%, and all weight percent values are based on the total weight of the composition.

In some aspects the composition includes from about 50 wt% to about 85 wt% of the thermoplastic polymer. Any suitable thermoplastic polymer can be used. In certain aspects the thermoplastic polymer includes polycarbonate (PC), poly(p-phenylene oxide) (PPO), aliphatic polyamide (PA), polyphthalamide (PPA), polyphenylene sulfide (PPS), polyester, liquid crystal polymer (LCP), polyether ether ketone (PEEK), copolymers thereof, or combinations thereof.

The composition may include from about 3 wt% to about 10 wt% of the laser activatable metal compound in some aspects. Any suitable laser activatable metal compound may be used, such as but not limited to copper chromite black spinel, copper hydroxide phosphate, or a combination thereof.

In some aspects the composition includes from about 10 wt% to about 50 wt% of the magnetic alloy. In particular aspects the composition includes from about 10 wt% to about 30 wt% of the magnetic alloy.

As used herein, a "magnetic alloy" is a combination of various metals from the periodic table such as ferrite that contains at least one magnetic element - such as but not necessarily limited to iron (Fe), nickel (Ni), or cobalt (Co) - and that does not include oxygen (O). A magnetic alloy must contain but is not limited to one or more of these metals.

In particular aspects the magnetic alloy includes, but is not limited to, magnetic molypermalloy powder (MPP), sendust, carbonyl iron particles (CIP), an iron-nickel alloy, or a combination thereof. Magnetic molypermalloy powder (MPP) is an iron-nickel-molybdenum based alloy. Sendust is an iron-silicon-aluminum based alloy. The iron-nickel alloy may include a 50/50 blend of iron and nickel in some aspects.

The composition may further include at least one additive in some aspects. Any suitable additive may be included in the composition, including but not limited to a non-magnetic filler, an impact modifier, a flow modifier, a reinforcing agent, an antioxidant, an heat stabilizer, a light stabilizer, an ultraviolet light stabilizer, an ultraviolet absorbing additive, a plasticizer, a lubricant, a release agent, an antistatic agent, an anti-fog agent, an antimicrobial agent, a chain extender, a colorant, a de-molding agent, a flow promoter, a flow modifier, a surface effect additive, a radiation stabilizer, a flame retardant, an anti-drip agent, or a combination thereof.

The composition may in some aspects have a magnetic permeability at 25 kilohertz (KHz) that is at least 100% higher than that of a substantially similar reference composition that does not include the magnetic alloy. Magnetic permeability may be determined using an impedance analysis with any conventional analyzer, such as but not limited to an Agilent Impedance Analyzer E4991A. In further aspects the composition has a magnetic permeability at 25 KHz that is at least 150% higher, or at least 200% higher, or at least 250% higher, than that of a substantially similar reference composition that does not include the magnetic alloy. As used herein, a "substantially similar reference composition" is a composition that includes the same components as the example composition, except that the reference composition does not include the recited component (e.g., the magnetic alloy). The reference composition includes additional thermoplastic polymer content to account for the removal of the recited component; otherwise the reference composition includes the same amounts of the components as those in the example composition.

In certain aspects the composition exhibits a magnetic loss of less than 2% at 25 kilohertz (KHz). In particular aspects the composition exhibits a magnetic loss of less than 1% at 25 kilohertz (KHz).

## Methods for Forming Laser Platable Thermoplastic Compositions

Aspects of the disclosure further relate to methods for forming laser platable thermoplastic compositions, including: forming a mixture by combining from about 40 wt% to about 90 wt% of a thermoplastic polymer, from about 1 wt% to about 15 wt% of a laser activatable metal compound, and from about 1 wt% to about 60 wt% of a magnetic filler; and extruding or melt blending the mixture to form the composition. The magnetic filler includes a magnetic alloy. The combined weight percent value of all components does not exceed 100 wt%, and all weight percent values are based on the total weight of the composition.

The laser platable thermoplastic compositions formed according to the described method may include any of the components, in any of the amounts, and have any of the properties described herein.

The one or any foregoing components described herein may be first dry blended with each other, or dry blended with any combination of foregoing components, then fed into an extruder from one or multi-feeders, or separately fed into an extruder from one or multi-feeders. The fillers used in the disclosure may also be first processed into a masterbatch, then fed into an extruder. The components may be fed into the extruder from a throat hopper or any side feeders.

The extruders used in the disclosure may have a single screw, multiple screws, intermeshing co-rotating or counter rotating screws, non-intermeshing co-rotating or counter rotating screws, reciprocating screws, screws with pins,

screws with screens, barrels with pins, rolls, rams, helical rotors, co-kneaders, disc-pack processors, various other types of extrusion equipment, or combinations including at least one of the foregoing.

The components may also be mixed together and then melt-blended to form the thermoplastic compositions. The melt blending of the components involves the use of shear force, extensional force, compressive force, ultrasonic energy, electromagnetic energy, thermal energy or combinations including at least one of the foregoing forces or forms of energy.

The barrel temperature on the extruder during compounding can be set at the temperature where at least a portion of the polycarbonate has reached a temperature greater than or equal to about the melting temperature, if the resin is a semi-crystalline organic polymer, or the flow point (e.g., the glass transition temperature) if the resin is an amorphous resin.

The mixture including the foregoing mentioned components may be subject to multiple blending and forming steps if desirable. For example, the thermoplastic composition may first be extruded and formed into pellets. The pellets may then be fed into a molding machine where it may be formed into any desirable shape or product. Alternatively, the thermoplastic composition emanating from a single melt blender may be formed into sheets or strands and subjected to post-extrusion processes such as annealing, uniaxial or biaxial orientation.

The temperature of the melt in the present process may in some aspects be maintained as low as possible in order to avoid excessive thermal degradation of the components. In some aspects the melt processed composition exits processing equipment such as an extruder through small exit holes in a die. The resulting strands of molten resin may be cooled by passing the strands through a water bath. The cooled strands can be chopped into pellets for packaging and further handling.

**Articles of Manufacture**

In certain aspects, the present disclosure pertains to shaped, formed, or molded articles including the thermoplastic compositions. The thermoplastic compositions can be molded into useful shaped articles by a variety of means such as injection molding, extrusion, rotational molding, blow molding and thermoforming to form the article. In particular aspects the article is an induction heater for a domestic or commercial appliance.

Various combinations of elements of this disclosure are encompassed by this disclosure, e.g., combinations of elements from dependent claims that depend upon the same independent claim.

**Aspects of the Disclosure**

In various aspects, the present disclosure pertains to and includes at least the following aspects.

Aspect 1. A laser platable thermoplastic composition comprising:

from about 40 wt% to about 90 wt% of a thermoplastic polymer;
from about 1 wt% to about 15 wt% of a laser activatable metal compound; and
from about 1 wt% to about 60 wt% of a magnetic filler comprising a magnetic alloy,
wherein the combined weight percent value of all components does not exceed 100 wt%, and all weight percent values are based on the total weight of the composition.

Aspect 2. The laser platable thermoplastic composition according to claim 1, wherein the composition comprises from about 50 wt% to about 85 wt% of the thermoplastic polymer.

Aspect 3. The laser platable thermoplastic composition according to claim 1 or 2, wherein the thermoplastic polymer comprises polycarbonate (PC), poly(p-phenylene oxide) (PPO), aliphatic polyamide (PA), polyphthalamide (PPA), polyphenylene sulfide (PPS), polyester, liquid crystal polymer (LCP), polyether ether ketone (PEEK), copolymers thereof, or a combination thereof.

Aspect 4. The laser platable thermoplastic composition according to any of claims 1 to 3, wherein the composition comprises from about 3 wt% to about 10 wt% of the laser activatable metal compound.

Aspect 5. The laser platable thermoplastic composition according to any of claims 1 to 4, wherein the laser activatable metal compound comprises copper chromite black spinel, copper hydroxide phosphate, or a combination thereof.

Aspect 6. The laser platable thermoplastic composition according to any of claims 1 to 5, wherein the composition comprises from about 10 wt% to about 50 wt% of the magnetic alloy.

Aspect 7. The laser platable thermoplastic composition according to any of claims 1 to 6, wherein the magnetic alloy comprises magnetic molypermalloy powder (MPP), sendust, carbonyl iron particles (CIP), an iron-nickel alloy, or a combination thereof.

Aspect 8. The laser platable thermoplastic composition according to any of claims 1 to 7, wherein the composition

further comprises at least one additive.

Aspect 9. The laser platable thermoplastic composition according to claim 8, wherein the at least one additive comprises a non-magnetic filler, an impact modifier, a flow modifier, a reinforcing agent, an antioxidant, an heat stabilizer, a light stabilizer, an ultraviolet light stabilizer, an ultraviolet absorbing additive, a plasticizer, a lubricant, a release agent, an antistatic agent, an anti-fog agent, an antimicrobial agent, a chain extender, a colorant, a de-molding agent, a flow promoter, a flow modifier, a surface effect additive, a radiation stabilizer, a flame retardant, an anti-drip agent, or a combination thereof.

Aspect 10. The laser platable thermoplastic composition according to any of claims 1 to 9, wherein the composition has a magnetic permeability at 25 KHz that is at least 100% higher than that of a substantially similar reference composition that does not include the magnetic alloy.

Aspect 11. The laser platable thermoplastic composition according to any of claims 1 to 10, wherein the composition exhibits a magnetic loss of less than 2% at 25 kilohertz (KHz).

Aspect 12. An article comprising the thermoplastic composition according to any of claims 1 to 10.

Aspect 13. The article according to claim 12, wherein the article is an induction heater for a domestic or commercial appliance.

Aspect 14. A method for forming a laser platable thermoplastic composition comprising:

forming a mixture by combining

from about 40 wt% to about 90 wt% of a thermoplastic polymer,
from about 1 wt% to about 15 wt% of a laser activatable metal compound, and
from about 1 wt% to about 60 wt% of a magnetic filler comprising a magnetic alloy; and

extruding or melt-blending the mixture to form the composition,
wherein the combined weight percent value of all components does not exceed 100 wt%, and all weight percent values are based on the total weight of the composition.

Aspect 15. The method according to claim 14, comprising combining about 50 wt% to about 85 wt% of the thermoplastic polymer in the mixture.

Aspect 16. The method according to claim 14 or 15, wherein the thermoplastic polymer comprises polycarbonate (PC), poly(p-phenylene oxide) (PPO), aliphatic polyamide (PA), polyphthalamide (PPA), polyphenylene sulfide (PPS), polyester, liquid crystal polymer (LCP), polyether ether ketone (PEEK), copolymers thereof, or a combination thereof.

Aspect 17. The method according to any of claims 14 to 16, comprising combining from about 3 wt% to about 10 wt% of the laser activatable metal compound in the mixture.

Aspect 18. The method according to any of claims 14 to 17, wherein the laser activatable metal compound comprises copper chromite black spinel, copper hydroxide phosphate, or a combination thereof.

Aspect 19. The method according to any of claims 14 to 18, comprising combining from about 10 wt% to about 50 wt% of the magnetic alloy in the mixture.

Aspect 20. The method according to any of claims 14 to 19, wherein the magnetic alloy comprises magnetic molypermalloy powder (MPP), sendust, carbonyl iron particles (CIP), an iron-nickel alloy, or a combination thereof.

Aspect 21. The method according to any of claims 14 to 20, further comprising combining at least one additive in the mixture.

Aspect 22. The laser platable thermoplastic composition according to claim 21, wherein the at least one additive comprises an impact modifier, a flow modifier, a reinforcing agent, an antioxidant, an heat stabilizer, a light stabilizer, an ultraviolet light stabilizer, an ultraviolet absorbing additive, a plasticizer, a lubricant, a release agent, an antistatic agent, an anti-fog agent, an antimicrobial agent, a chain extender, a colorant, a de-molding agent, a flow promoter, a flow modifier, a surface effect additive, a radiation stabilizer, a flame retardant, an anti-drip agent, or a combination thereof.

Aspect 23. The method according to any of claims 14 to 22, wherein the composition has a magnetic permeability at 25 KHz that is at least 100% higher than that of a substantially similar reference composition that does not include the magnetic alloy.

Aspect 24. The method according to any of claims 14 to 23, wherein the composition exhibits a magnetic loss of less than 2% at 25 kilohertz (KHz).

Aspect 25. An article comprising the thermoplastic composition formed according to the method of any of claims 14 to 24.

Aspect 26. The article according to claim 25, wherein the article is an induction heater for a domestic or commercial appliance.

## EXAMPLES

The following examples are put forth so as to provide those of ordinary skill in the art with a complete disclosure and description of how the compounds, compositions, articles, devices and/or methods claimed herein are made and evaluated, and are intended to be purely exemplary and are not intended to limit the disclosure. Efforts have been made to ensure accuracy with respect to numbers (e.g., amounts, temperature, etc.), but some errors and deviations should be accounted for. Unless indicated otherwise, parts are parts by weight, temperature is in °C or is at ambient temperature, and pressure is at or near atmospheric. Unless indicated otherwise, percentages referring to composition are in terms of wt%.

There are numerous variations and combinations of reaction conditions, e.g., component concentrations, desired solvents, solvent mixtures, temperatures, pressures and other reaction ranges and conditions that can be used to optimize the product purity and yield obtained from the described process. Only reasonable and routine experimentation will be required to optimize such process conditions.

The compositions described herein were extruded into pellets according to conventional methods and under the conditions described in Table 1:

Table 1 - Extrusion Profile

| Parameter | Unit | Extrusion Condition |
|---|---|---|
| Compounder Type | NONE | TEM-37BS |
| Barrel Size | mm | 1500 |
| Die | mm | 4 |
| Zone 1 Temp | °C | 90 |
| Zone 2 Temp | °C | 150 |
| Zone 3 Temp | °C | 280 |
| Zone 4 Temp | °C | 280 |
| Zone 5 Temp | °C | 280 |
| Zone 6 Temp | °C | 280 |
| Zone 7 Temp | °C | 280 |
| Zone 8 Temp | °C | 290 |
| Zone 9 Temp | °C | 290 |
| Zone 10 Temp | °C | 290 |
| Zone 11 Temp | °C | 290 |
| Die Temp | °C | 290 |
| Screw speed | rpm | 300 |
| Throughput | kg/hr | 30 |
| Torque | NONE | 50-60 |
| Vacuum 1 | MPa | -0.08 |
| Side Feeder 1 speed | rpm | 250 |
| Melt temperature | NONE | 280-290 |

The extruded pellets were injection molded according to conventional methods and under the conditions described in Table 2:

Table 2 - Injection Molding Profile

| Parameters | Unit | Molding Condition |
|---|---|---|
| Cnd: Pre-drying time | Hour | 3 |

(continued)

| Parameters | Unit | Molding Condition |
|---|---|---|
| Cnd: Pre-drying temp | °C | 105 |
| Molding Machine | NONE | FANUC, UH1000-110 |
| Mold Type (insert) | NONE | ASTM Tensile, Flexural, Izod bars, 90*50*2.54 mm Color Chips, 2.0 & 1.5 & 1.0 mm thickness UL bars |
| Hopper temp | °C | 50 |
| Zone 1 temp | °C | 270-280 |
| Zone 2 temp | °C | 280-290 |
| Zone 3 temp | °C | 290-300 |
| Nozzle temp | °C | 280-290 |
| Mold temp | °C | 90-120 |
| Screw speed | rpm | 100 |
| Back pressure | $kgf/cm^2$ | 90 |
| Cooling time | s | 15-30 |
| Injection speed | mm/s | 25-500 |
| Holding pressure | $kgf/cm^2$ | 600-1000 |
| Max. Injection pressure | $kgf/cm^2$ | 1000-2500 |

Comparative (C1.1) and example (E1.1 and E1.2) compositions were formed having the compositions set forth in Table 3:

Table 3 - Compositions Formed

| Item Description | Unit | C1.1 | E1.1 | E1.2 |
|---|---|---|---|---|
| Poly(p-phenylene oxide) (PPO), 0.40IV | % | 66.7 | 56.7 | 36.7 |
| PPO, 0.12IV | % | 10 | 10 | 10 |
| KRATON™ SEBS G1651 (styrene-ethylene/butylene-styrene), high molecular weight | % | 6 | 6 | 6 |
| PhenoxyPhosphazene (PPZ) | % | 8 | 8 | 8 |
| Copper Chromite Black Spinel, CuCrO | % | 8 | 8 | 8 |
| Linear low density polyethylene (LLDPE) | % | 1 | 1 | 1 |
| Magnesium oxide | % | 0.1 | 0.1 | 0.1 |
| MPP powder (iron-nickel-molybdenum alloy) (Magnetic alloy) | % | 0 | 10 | 30 |
| Zinc sulfide | % | 0.1 | 0.1 | 0.1 |
| Phosphite Stabilizer | % | 0.1 | 0.1 | 0.1 |

Various properties of the compositions were tested; results are shown in Table 4:

Table 4 - Properties of Compositions

| Property | Test Description | Test Conditions | Unit | C1.1 | E1.1 | E1.2 |
|---|---|---|---|---|---|---|
| MVR | ASTM D1238 | 300°C/5.0kg | $cm^3/10min$ | 15 | 13.4 | 12.6 |
| Notched IZOD | ASTM D256 | 23°C, 5 lbf/ft | J/m | 250 | 60 | 46 |
| Ductility | ASTM D256 | 23°C,5 lbf/ft | % | 100 | 0 | 0 |

(continued)

| Property | Test Description | Test Conditions | Unit | C1.1 | E1.1 | E1.2 |
|---|---|---|---|---|---|---|
| HDT | ASTM D648 | 0.45 MPa/3.2 mm | °C | 150 | 151 | 148 |
| HDT | ASTM D648 | 1.82 MPa/3.2 mm | °C | 170 | 170 | 165 |
| Flexural Modulus | ASTM D790 | 3.2 mm, 1.27 mm/min | MPa | 2200 | 2570 | 3100 |
| Flexural Strength | ASTM D790 | @break, 3.2 mm, 1.27 mm/min | MPa | 89 | 81 | 78 |
| Tensile Modulus | ASTM D638 | 50 mm/min | MPa | 2250 | 2716 | 3215 |
| Tensile Strength | ASTM D638 | @break, 50 mm/min | MPa | 54 | 50 | 50 |
| Tensile Elongation | ASTM D638 | @break, 50 mm/min | % | 10.7 | 4.0 | 2.6 |
| Magnetic Permeability | Impedance analyzer | 25KHz | | 1 | 2.3 | 3.6 |
| Magnetic Loss | Impedance analyzer | 25KHz | | 0.00 | 0.01 | 0.01 |

Comparative composition C1.1 did not include a magnetic alloy; example compositions E1.1 and E1.2 included 10 wt% and 30 wt% respectively of an iron-nickel-molybdenum alloy (magnetic alloy). From the data in Table 4 it was observed that, as expected, the ductility of the compounds decreased when with the introduction of a filler (in this case the magnetic alloy) due to less adhesion between the filler and the polymer resin. The modulus of the example compositions increased, and the tensile strength was comparable to the comparative composition. Overall, the mechanical properties of the example compositions were sufficiently maintained for the desired application. Significantly, the magnetic permeability and loss properties of E1.1 and E1.2 were substantially improved. Specifically, magnetic permeability improved by more than double or triple that of the C1. In addition, while the comparative composition C1 did not generate a magnetic field at all (and thus had no magnetic loss), the example compositions had a magnetic loss of only 1%.

The enhanced magnetic properties of the compositions of the present disclosure allow for their use in applications such as, but not limited to, induction heater applications.

Method examples described herein can be machine or computer-implemented at least in part. Some examples can include a computer-readable medium or machine-readable medium encoded with instructions operable to configure an electronic device to perform methods as described in the above examples. An implementation of such methods can include code, such as microcode, assembly language code, a higher-level language code, or the like. Such code can include computer readable instructions for performing various methods. The code may form portions of computer program products. Further, in an example, the code can be tangibly stored on one or more volatile, non-transitory, or non-volatile tangible computer-readable media, such as during execution or at other times. Examples of these tangible computer-readable media can include, but are not limited to, hard disks, removable magnetic disks, removable optical disks (e.g., compact disks and digital video disks), magnetic cassettes, memory cards or sticks, random access memories (RAMs), read only memories (ROMs), and the like.

The above description is intended to be illustrative, and not restrictive. For example, the above-described examples (or one or more aspects thereof) may be used in combination with each other. Other aspects can be used, such as by one of ordinary skill in the art upon reviewing the above description. The Abstract is provided to comply with 37 C.F.R. § 1.72(b), to allow the reader to quickly ascertain the nature of the technical disclosure. It is submitted with the understanding that it will not be used to interpret or limit the scope or meaning of the claims. Also, in the above Detailed Description, various features may be grouped together to streamline the disclosure. This should not be interpreted as intending that an unclaimed disclosed feature is essential to any claim. Rather, inventive subject matter may lie in less than all features of a particular disclosed aspect. Thus, the following claims are hereby incorporated into the Detailed Description as examples or aspects, with each claim standing on its own as a separate aspect, and it is contemplated that such aspects can be combined with each other in various combinations or permutations. The scope of the disclosure should be determined with reference to the appended claims, along with the full scope of equivalents to which such claims are entitled.

## Claims

**1.** A laser platable thermoplastic composition comprising:

from about 40 wt% to about 90 wt% of a thermoplastic polymer;
from about 1 wt% to about 15 wt% of a laser activatable metal compound; and
from about 1 wt% to about 60 wt% of a magnetic filler comprising a magnetic alloy,
wherein the combined weight percent value of all components does not exceed 100 wt%, and all weight percent values are based on the total weight of the composition.

**2.** The laser platable thermoplastic composition according to claim 1, wherein the composition comprises from about 50 wt% to about 85 wt% of the thermoplastic polymer.

**3.** The laser platable thermoplastic composition according to claim 1 or 2, wherein the thermoplastic polymer comprises polycarbonate (PC), poly(p-phenylene oxide) (PPO), aliphatic polyamide (PA), polyphthalamide (PPA), polyphenylene sulfide (PPS), polyester, liquid crystal polymer (LCP), polyether ether ketone (PEEK), copolymers thereof, or a combination thereof.

**4.** The laser platable thermoplastic composition according to any of claims 1 to 3, wherein the composition comprises from about 3 wt% to about 10 wt% of the laser activatable metal compound.

**5.** The laser platable thermoplastic composition according to any of claims 1 to 4, wherein the laser activatable metal compound comprises copper chromite black spinel, copper hydroxide phosphate, or a combination thereof.

**6.** The laser platable thermoplastic composition according to any of claims 1 to 5, wherein the composition comprises from about 10 wt% to about 50 wt% of the magnetic alloy.

**7.** The laser platable thermoplastic composition according to any of claims 1 to 6, wherein the magnetic alloy comprises magnetic molypermalloy powder (MPP), sendust, carbonyl iron particles (CIP), an iron-nickel alloy, or a combination thereof.

**8.** The laser platable thermoplastic composition according to any of claims 1 to 7, wherein the composition further comprises at least one additive.

**9.** The laser platable thermoplastic composition according to claim 8, wherein the at least one additive comprises a non-magnetic filler, an impact modifier, a flow modifier, a reinforcing agent, an antioxidant, an heat stabilizer, a light stabilizer, an ultraviolet light stabilizer, an ultraviolet absorbing additive, a plasticizer, a lubricant, a release agent, an antistatic agent, an anti-fog agent, an antimicrobial agent, a chain extender, a colorant, a de-molding agent, a flow promoter, a flow modifier, a surface effect additive, a radiation stabilizer, a flame retardant, an anti-drip agent, or a combination thereof.

**10.** The laser platable thermoplastic composition according to any of claims 1 to 9, wherein the composition has a magnetic permeability at 25 kilohertz (KHz) that is at least 100% higher than that of a substantially similar reference composition that does not include the magnetic alloy.

**11.** The laser platable thermoplastic composition according to any of claims 1 to 10, wherein the composition exhibits a magnetic loss of less than 2% at 25 KHz.

**12.** An article comprising the thermoplastic composition according to any of claims 1 to 10.

**13.** The article according to claim 12, wherein the article is an induction heater for a domestic or commercial appliance.

**14.** A method for forming a laser platable thermoplastic composition comprising:

forming a mixture by combining

from about 40 wt% to about 90 wt% of a thermoplastic polymer,
from about 1 wt% to about 15 wt% of a laser activatable metal compound, and
from about 1 wt% to about 60 wt% of a magnetic filler comprising a magnetic alloy; and

extruding or melt-blending the mixture to form the composition,
wherein the combined weight percent value of all components does not exceed 100 wt%, and all weight percent

values are based on the total weight of the composition.

**15.** The method according to claim 14, comprising combining about 50 wt% to about 85 wt% of the thermoplastic polymer in the mixture.

Europäisches Patentamt
European Patent Office
Office européen des brevets

# EUROPEAN SEARCH REPORT

Application Number
EP 19 17 1258

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2016/355679 A1 (AEPLI ETIENNE [CH]) 8 December 2016 (2016-12-08) | 1-5, 8-12,14, 15 | INV. C08K3/11 |
| A | * claim 1 * * example 1 * * paragraph [0091] - paragraph [0099] * ----- | 6,7,13 | ADD. C08K3/08 C08L69/00 C08L71/00 C08L77/00 C08L81/02 H05K1/00 |
| X | US 2016/276072 A1 (SETHUMADHAVAN MURALI [US] ET AL) 22 September 2016 (2016-09-22) | 1-12 | |
| A | * claims 1-5, 11 * * paragraph [0002] - paragraph [0004] * * paragraph [0068] * ----- | 13-15 | |

TECHNICAL FIELDS SEARCHED (IPC)

C09J
C08K
C08L
H05K

The present search report has been drawn up for all claims

1

| Place of search | Date of completion of the search | Examiner |
|---|---|---|
| Munich | 28 October 2019 | Laudi, Ines |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

# ANNEX TO THE EUROPEAN SEARCH REPORT ON EUROPEAN PATENT APPLICATION NO. EP 19 17 1258

This annex lists the patent family members relating to the patent documents cited in the above-mentioned European search report.
The members are as contained in the European Patent Office EDP file on
The European Patent Office is in no way liable for these particulars which are merely given for the purpose of information.

28-10-2019

| Patent document cited in search report | Publication date | Patent family member(s) | Publication date |
|---|---|---|---|
| US 2016355679 A1 | 08-12-2016 | CA 2934611 A1 | 25-06-2015 |
| | | CN 105849197 A | 10-08-2016 |
| | | EP 3083832 A1 | 26-10-2016 |
| | | JP 2017500418 A | 05-01-2017 |
| | | KR 20160100912 A | 24-08-2016 |
| | | TW 201623443 A | 01-07-2016 |
| | | US 2016355679 A1 | 08-12-2016 |
| | | WO 2015091429 A1 | 25-06-2015 |
| US 2016276072 A1 | 22-09-2016 | CN 107347258 A | 14-11-2017 |
| | | DE 112016001291 T5 | 07-12-2017 |
| | | GB 2550738 A | 29-11-2017 |
| | | JP 2018517273 A | 28-06-2018 |
| | | KR 20170139519 A | 19-12-2017 |
| | | TW 201640530 A | 16-11-2016 |
| | | US 2016276072 A1 | 22-09-2016 |
| | | WO 2016149465 A1 | 22-09-2016 |

EPO FORM P0459

For more details about this annex : see Official Journal of the European Patent Office, No. 12/82